# EUROPEAN PATENT APPLICATION

(11) **EP 4 773 792 A1**
(43) Date of publication of application: **08.07.2026**
(21) Application number: 25219861.9
(22) Date of filing: 01.12.2025
(51) Int. Cl.: H10P 34/42

(54) **PURGE GAS LAMINAR FLOW DESIGN AND WITH SPECIFIC PATTERN FOR LASER PROCESSING**

(30) Priority: 06.12.2024 US 202463728957 P; 27.01.2025 US 202519037623
(71) Applicant: II-VI Delaware, Inc., Wilmington, DE 19890 (US)
(72) Inventor: WU, Chan, Wilmington, 19890 (US); RULE, Toby, Wilmington, 19890 (US)
(74) Representative: Schmidt, Christian

(57) **Abstract**

This disclosure describes systems and methods for designing a wafer annealing chamber that combines laminar or near laminar purge gas flows across the wafer, higher flow and pressure in the upper portion of the chamber, and a specific progression of the lasing pattern relative to the purge gas laminar flow direction.

## Description

### CROSS REFERENCE TO RELATED APPLICATIONS

This application claims priority to and the benefit of U.S. Provisional Patent Application No. 63/728,957 entitled "PURGE GAS LAMINAR FLOW DESIGN AND WITH SPECIFIC PATTERN FOR LASER PROCESSING" filed December 6, 2024, which is hereby incorporated herein by reference in its entirety.

### BACKGROUND

Limitations and disadvantages of traditional methods and systems for laser annealing will become apparent to one of skill in the art, through comparison of such approaches with some aspects of the present method and system set forth in the remainder of this disclosure with reference to the drawings.

### BRIEF SUMMARY

Systems and methods for designing a controlled atmosphere chamber, substantially as illustrated by and/or described in connection with at least one of the figures, are set forth more completely in the claims.

### BRIEF DESCRIPTION OF THE DRAWINGS

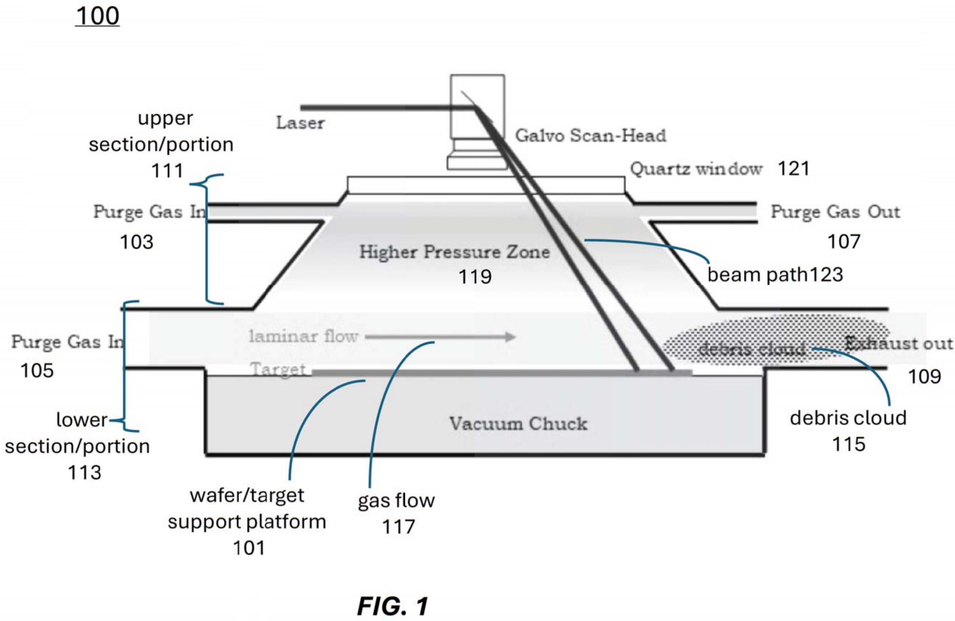

FIG. 1 illustrates a side view of an example wafer annealing chamber, in accordance with various example implementations of this disclosure.

### DETAILED DESCRIPTION

The following discussion provides various examples of an annealing chamber. Such examples are non-limiting, and the scope of the appended claims should not be limited to the particular examples disclosed. In the following discussion, the terms "example" and "e.g." are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

The terms "comprises," "comprising," "includes," and/or "including," are "open ended" terms and specify the presence of stated features, but do not preclude the presence or addition of one or more other features.

The terms "first," "second," etc. may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

This disclosure relates to laser annealing to create improved electrical contacts for semiconductor devices.

Lasing energy is required to convert an as-deposited, metal thin-film and the surface layer of the underlying silicon carbide (SiC) substrate into a silicide ohmic contact. However, this lasing energy induces partial vaporization of the target metal and substrate. The vaporization may generate a debris cloud that partially absorbs the incoming lasing energy. The vaporization may also contaminate nearby unannealed surfaces. The resulting partial absorption or scattering results in a variation of the laser energy delivered to the target area, thereby reducing the process efficacy.

This disclosure relates to laser annealing to create improved electrical contacts for semiconductor devices.

FIG. 1 illustrates a side view of an example wafer annealing chamber 100, in accordance with various example implementations of this disclosure.

The laser annealing chamber 100 is designed to optimize debris management and ensure uniform annealing of SiC wafers. Central to the design is a wafer support platform 101 located within a chamber featuring either a rectangular or cylindrical geometry. Purge gas inlets 103, 105 are strategically placed along one side of the chamber, while exhaust outlets 107, 109 are positioned on the opposite side. This configuration facilitates a directed gas flow that sweeps across the wafer surface. To enhance debris management, the upper section 111 of the chamber is conical, creating a higher-pressure zone 119. This pressure gradient may provide that the purge gas flow in the lower portion 113 of the chamber is directional and effective, minimizing turbulence and directing debris 115 toward the exhaust system without interfering with the laser beam path 123.

The chamber 100 comprises a gas flow mechanism that uses an array of nozzles or elongated openings to introduce a laminar or near-laminar gas flow 117 across the wafer. This flow may be calibrated to maintain a velocity range of 0.4 m/s to 1.2 m/s, ensuring the efficient removal of debris particles from the wafer surface. The choice of gas composition, comprising inert gases like nitrogen (N₂) or argon (Ar), may enhance the annealing process by preventing unwanted chemical reactions during the process.

Debris management is a critical aspect of this disclosure, addressing the challenges posed by vaporized particles during the laser annealing process. As the intense lasing energy interacts with the wafer, it generates a debris cloud 115 of carbon nanoparticles and other particulates. The system is designed to control and remove this debris before it can interfere with the annealing process or settle on critical surfaces.

The laminar purge gas flow 117 plays a central role in debris control. By maintaining a consistent and directional flow across the wafer surface, the system ensures that debris particles 115 remain suspended and are efficiently carried toward the exhaust outlets 109. This prevents resettling of particles on the wafer 101 or within the chamber. Additionally, the conical design of the upper chamber 111 maintains a higher-pressure zone 119, which acts as a barrier, preventing debris from contaminating the laser beam entry quartz window 121. This feature ensures consistent laser delivery 123, reduces the frequency of maintenance, and prolongs the operational lifespan of the chamber components. The chamber may comprise an internal coating to reduce debris adhesion. The quartz window 121 may comprise an anti-contamination coating.

This disclosure incorporates a novel approach to the interaction between the laser annealing process and the purge gas flow 117. The lasing pattern progresses in the direction opposite to the laminar gas flow 117. In some embodiments, the galvo scan head may move the beam while the chuck stays fixed. In other embodiments, the chuck may move. This ensures that each area of the wafer is annealed on a clean surface, as debris generated from earlier lasing operations is continuously swept away before the laser reaches subsequent areas.

This synchronized interaction between the lasing pattern 123 and the purge gas flow 117 significantly enhances the uniformity and efficiency of the annealing process. By preventing debris clouds 115 from interfering with the laser beam 123, the system ensures consistent energy delivery to the wafer surface 101, leading to improved annealing results. The method also reduces surface irregularities and enhances the overall quality and appearance of the treated wafer. This innovative approach makes the system highly effective for achieving uniform annealing while addressing the common challenges of debris-related contamination.

This disclosure may relate to the following implementations: This disclosure describes systems and methods for designing a wafer annealing chamber that combines laminar or near laminar purge gas flows across the wafer, higher flow and pressure in the upper portion of the chamber, and a specific progression of the lasing pattern relative to the purge gas laminar flow direction.

The present application claims priority of US patent application 63/728,957 filed on December 6, 2024, and of US patent application 19/037,623 filed on January 27, 2025. The entire disclosure content of these applications is hereby incorporated herein by reference for all purposes.

In the following, a set of items is disclosed. The items are numbered to facilitate referencing the features of one item in other items. The items form part of the present disclosure and could be made subject to independent and/or dependent claims irrespective of what currently is claimed in the application. We note, however, that the scope of protection is defined by the appended claims, where the following items do not constitute claims. The items are:
1. A method for laser annealing, comprising:
   directing a laminar gas flow across a wafer in a lower portion of a chamber;
   generating a pressure boundary in an upper portion of the chamber; and
   laser annealing in a direction opposite to the laminar gas flow.
2. The method of item 1, wherein the laminar gas flow uses a purge gas that comprises one or more of nitrogen, argon, and an inert gas mixture.
3. The method of item 1, wherein the chamber comprises an array of inlet nozzles.
4. The method of item 1, wherein the upper portion of the chamber is conical.
5. The method of item 1, wherein a gas flow velocity is adjusted according to wafer size.
6. The method of item 1, wherein the laser annealing uses a laser wavelength absorbed by a metal layer.
7. The method of item 1, wherein pressure in the chamber is maintained below atmospheric levels by a vacuum pump.
8. The method of item 1, wherein the pressure boundary prevents particles, of sizes ranging from 0.01 µm to 1.0 µm, from entering the upper portion of the chamber.
9. The method of item 1, wherein the chamber comprises a debris collection system in an exhaust path.
10. The method of item 1, wherein the laser annealing is configured to minimize energy scattering by a debris cloud.
11. A laser annealing system, comprising:
   a chamber comprising a lower chamber portion and an upper chamber portion;
   an array of inlet nozzles configured to generate a laminar gas flow across a wafer;
   a laser system configured to anneal the wafer with a lasing pattern progressing in a direction opposite to the laminar gas flow; and
   an exhaust system configured to remove vaporized debris without re-depositing on the wafer.
12. The system of item 11, wherein a purge gas flow velocity is adjustable between 0.4 and 1.2 m/s.
13. The system of item 11, wherein the laser annealing system comprises a vacuum pump configured to maintain a sub-atmospheric chamber pressure.
14. The system of item 11, wherein the laser system operates at a wavelength optimized for nickel silicide formation.
15. The system of item 11, wherein the exhaust system comprises a debris collection unit.
16. The system of item 11, wherein the chamber comprises an internal coating configured to reduce debris adhesion.
17. The system of item 11, wherein a direction of the laminar flow is perpendicular to a rotation axis of the wafer.
18. The system of item 11, wherein a lasing pattern is configurable according to a size and a material of the wafer.
19. The system of item 11, wherein the laser annealing system comprises one or more sensors configured to monitor gas flow uniformity.
20. The system of item 11, wherein the chamber comprises a quartz window with an anti-contamination coating.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A method for laser annealing, comprising:
directing a laminar gas flow across a wafer in a lower portion of a chamber;
generating a pressure boundary in an upper portion of the chamber; and
laser annealing in a direction opposite to the laminar gas flow.

2. The method of claim 1, wherein the laminar gas flow uses a purge gas that comprises one or more of nitrogen, argon, and an inert gas mixture.

3. The method of any one of the preceding claims, wherein the chamber comprises an array of inlet nozzles.

4. The method of any one of the preceding claims, wherein the upper portion of the chamber is conical.

5. The method of any one of the preceding claims, wherein a gas flow velocity is adjusted according to wafer size.

6. The method of any one of the preceding claims, wherein the laser annealing uses a laser wavelength absorbed by a metal layer.

7. The method of any one of the preceding claims, wherein pressure in the chamber is maintained below atmospheric levels by a vacuum pump.

8. The method of any one of the preceding claims, wherein the pressure boundary prevents particles, of sizes ranging from 0.01 µm to 1.0 µm, from entering the upper portion of the chamber.

9. The method of any one of the preceding claims, wherein the chamber comprises a debris collection system in an exhaust path.

10. The method of any one of the preceding claims, wherein the laser annealing is configured to minimize energy scattering by a debris cloud.

11. A laser annealing system, comprising:
a chamber comprising a lower chamber portion and an upper chamber portion;
an array of inlet nozzles configured to generate a laminar gas flow across a wafer;
a laser system configured to anneal the wafer with a lasing pattern progressing in a direction opposite to the laminar gas flow; and
an exhaust system configured to remove vaporized debris without re-depositing on the wafer.

12. The system of claim 11, wherein
a) a purge gas flow velocity is adjustable between 0.4 and 1.2 m/s, and/or
b) the laser annealing system comprises a vacuum pump configured to maintain a sub-atmospheric chamber pressure, and/or
c) the laser system operates at a wavelength optimized for nickel silicide formation, and/or
d) the exhaust system comprises a debris collection unit, and/or
e) a lasing pattern is configurable according to a size and a material of the wafer, and/or
f) the chamber comprises a quartz window with an anti-contamination coating.

13. The system of claim 11 or 12, wherein the chamber comprises an internal coating configured to reduce debris adhesion.

14. The system of any one of claims 11 to 13, wherein a direction of the laminar flow is perpendicular to a rotation axis of the wafer.

15. The system of any one of claims 11 to 14, wherein the laser annealing system comprises one or more sensors configured to monitor gas flow uniformity.
